# EUROPEAN PATENT SPECIFICATION

(11) **EP 0 826 434 B1**
(45) Date of publication and mention of the grant of the patent: **16.06.2004**
(21) Application number: 96830429.5
(22) Date of filing: 31.07.1996
(51) Int. Cl.: B05D 7/24, C23C 14/06, C23C 14/54, C08G 73/10, C09D 179/08

(54) **Process and apparatus for preparing thin films of polymers and composite materials on different kind of substrates**
Verfahren und Vorrichtung zur Herstellung von dünnen Filmen aus Polymeren oder Verbundmaterialien auf verschiedenen Substraten
Procédé et appareil pour préparer des films minces de polymères et de matières composites sur différents types de substrats

(43) Date of publication of application: 04.03.1998
(73) Proprietor: ISTITUTO NAZIONALE DI FISICA NUCLEARE, I-00044 Frascati (RM) (IT)
(72) Inventor: Carturan, Sara, I-35020 Albignasego (Prov. of Padova) (IT); Della Mea, Gianantonio, I-35030 Selvazzano Dentro (IT); Pieri, Ugo, I-35133 Padova (IT)
(74) Representative: Sarpi, Maurizio

(56) References cited:
- EP-A- 0 278 629
- EP-A- 0 376 333
- FR-A- 2 297 900
- US-A- 4 629 547
- US-A- 5 354 636
- JOURNAL OF VACUUM SCIENCE AND TECHNOLOGY: PART A, vol. 4, no. 3, May 1986 - June 1986, NEW YORK US, pages 369-374, XP002022479 J.R.SALEM ET AL.: "Solventless polyimide films by vapor deposition"
- MACROMOLECULES, vol. 22, 1989, EASTON US, pages 2944-2946, XP002022480 M. IIJIMA ET AL.: "Vapor Deposition Polymerization: A Study on Film Formation in Reaction of Pyromellitic Anhydride and Bis(4-aminophenyl) Ether"
- PATENT ABSTRACTS OF JAPAN vol. 013, no. 060 (M-796), 10 February 1989 & JP 63 264369 A (TOSHIBA CORP), 1 November 1988,
- DATABASE WPI Section Ch, Week 9346 Derwent Publications Ltd., London, GB; Class A26, AN 93-362184 XP002022481 & JP 05 265 006 A (SHARP KK) , 15 October 1993
- PATENT ABSTRACTS OF JAPAN vol. 015, no. 132 (C-0819), 29 March 1991 & JP 03 013561 A (ULVAC CORP), 22 January 1991,
- PATENT ABSTRACTS OF JAPAN vol. 015, no. 051 (P-1163), 6 February 1991 & JP 02 282947 A (SEIKO EPSON CORP), 20 November 1990,
- PATENT ABSTRACTS OF JAPAN vol. 013, no. 069 (C-569), 16 February 1989 & JP 63 259069 A (SUMITOMO ELECTRIC IND LTD), 26 October 1988,

## Description

The present invention relates to a process and an apparatus for preparing thin films of polyimide polymers, hereinafter referred to as FIPOL I, FIPOL II and FIPOL III for the sake of brevity, on a solid substrate of various chemical composition for the modification of chemical-physical surface characteristics of such a substrate. Particularly, solid substrates such as, for example, inorganic oxides such as glass, SiO₂, Al₂O₃ or metals such as Ti, Cu, Al or non-metals such as Si, C, Ge may be used. Said polyimide polymers differ in structure and morphology from the polyimides already chemically produced by Dupont De Nemours and by UBE and known under the trademarks KAPTON® and UPILEX®, even if they have similar chemical formula.

By way of example, the surface deposits provided by the described process may be advantageously used for the protection of metal objects since such a process allows homogeneous controlled-thickness films to be prepared irrespective of the geometric form and the nature of the substrate. As chemically inert polymeric films stable up to 400°C are concerned, the process allows the fields of application of said materials modified in their mechanical, electrical, optical surface characteristics to be advantageously extended.

Another field of application relates to the preparation of polyimide-metal surface deposits by one and only process of providing films having a typical conductivity of a semiconductor, then adapted in micro-electronics and electrostatics. Such a composite material is referred to as CONPOL (registered trademark by the Applicant) in the following description.

The above-cited fields of application of the invention are only some of the main fields indicated by way of a not limiting example of the invention since the process, the used materials, the organic, metal and organometal precursors, as described and claimed later on, may be advantageously used in any other equivalent field in which polyimide deposits modified or not by means of metals are produced on solid substrates to cause a permanent modification of the surface characteristics.

Processes of such a type are known. Particularly the process of the article of Salem et al, *(Journal* of *Vacuum Science & Technology,* A4 (3), 1986, page 369) relates to the preparation of polyimide films of the type FIPOL I to be deposited on various substrates by using a highly specific apparatus for controlling the process of evaporation which does not allow surfaces of large size or lower than some square centimetres to be treated. Also Pethe et al. *(Journal of Material Research,* Vol. 8, No. 12, 1993, page 3218) disclose a process for depositing polyimide films of the type FIPOL I by using a very expensive apparatus not adapted to the treatment of wide surfaces. Further processes such as those disclosed by Lamb et al. *(Lagmuir*- Vol. 4, 1988, page 249), Yamada et al. *(Journal of Vacuum Science & Technology,* Al 1 (5), 1993, page 2590), Iijma et al. (Macromolecules, Vol. 22, 1989, page 2944) have technical drawbacks which can be overcome only by specific research instruments and then are not adapted for a continuous industrial production.

It is known, from EP 0 278 629, an amorphous material and a process for producing the same, which comprises simultaneously vacuum depositing or sputtering of a polymer and a metal or a metalloid. It should be noted that the metal or metalloid included in the polymeric matrix according the process of EP 0 278 629 is evaporated by electron gun or by sputtering which are very expensive. In addition, in such known process the metal or metalloid is obtained as vapor starting from the element in its metallic form, thus requiring high operating temperatures. Furthermore, in EP 0 278 629 the polymer is evaporated by heating resistances starting from the polymeric material and not from its monomeric precursors. The authors of such document indicate, as possible evaporable polymers, also the polyimide that, as well-known, decomposes itself at a temperature comprised between 400 and 600°C without melting, releasing gaseous products such as carbon dioxide, carbon monoxide, benzene, and so on (C. Sroog, *J. Polymer Science,* vol. 11, 161-208, 1976). It seems highly improbable the reconstruction of the original chemical structure if the polyimide on the walls of the apparatus and on the substrates to be covered. Finally, the electric conductivity features of the material obtained according to EP 0 278 629 are not disclosed therein.

It is also known, from US4629547, a process for forming protective film having a very low coefficient of friction, a good wear resistance, a good adhesion, and prolonged lubricating and moisture-resistant properties, wherein said film is formed on a substrate by sputtering of a target consisting of at least one of organic polymers and at least one of boron compounds. Such known process is quite different from the present invention because it does not relate a vapor deposition polymerization process but it concerns a sputtering vacuum chamber wherein it is required the erosion of a massive material performed by a ionized inert gas in the form of plasma. Moreover, among the polymers cited in US4629547 as usable in that sputtering process, it is mentioned the polyimide that, as demonstrated in publications posterior to D2, it is not obtainable with such technique (G. Hishmeh et al., *J. Vac. Sci. & Technology*, A 14, 130, 1996; Kitoh el al. *Thin Solid Films,* vol. 271, 92-95, 1995).

From abstract of JP02282947, it is known a material that is a generic composite polyimide-graphite obtained by vacuum deposition, but in order to obtain a simultaneous evaporation of the monomer and of the graphite it is necessary to use an electron gun at a temperature higher than 5000°C!

Furthermore, it is known, from abstract of JP63264369 a process for manufacturing a thermal head, wherein a film of polyamide acid becoming the precursor of a polyimide resin, under vacuum to form polyamide acid to the main surface of a metal substrate and subsequently applying heat-treatment thereto to form a polyimide resin layer on the metal substrate. Thereafter, the metal substrate having polyamide acid thus formed thereto is taken out from the vacuum atmosphere and heated in a nitrogen atmosphere to convert polyamide acid to polyimide to form a polyimide resin layer. Subsequently, a heat generating resistor layer and an electrode layer protecting film are formed on the polyimide resin layer by sputtering to complete a thermal head. It should be noted that such known process is specifically intended to realize a layer of polyimide resin on a metal substrate, while the process according to the invention in object is specifically intended to realize an homogeneous, thin layer of a polyimide-metal composite material.

Furthermore, as will be clearly disclosed hereinafter, differently from the prior art, the present invention allows to modulate the process so as to be able to vary the thickness of the film according to the evaporation time and the kind of the substrate and to provide such surface deposits without any limitation in the extension of the treated surface, without discontinuity or modifications of the chemical-physical characteristics of the deposited polyimide-metal composite material.

The main object of the present invention is of overcoming the above-complained problems and limitations by a process which allows compact polyimide films such as the so-called FIPOL I, FIPOL II, FIPOL III and compositions thereof with metals to be provided by a controlled-thickness process for the modification of the chemical-physical surface characteristics of solid substrates of various kind without any limitations of the treated surface area.

A second object of the present invention is of providing deposits having half-insulation characteristics on varying-geometry substrates by one and only process.

A further object of the present invention is of providing polyimide films FIPOL I, FIPOL II, FIPOL III having no internal separation surfaces or cracks and exhibiting the same mechanical characteristics and the same surface tension values, chemical etching resistance and thermal endurance as the massive polyimide materials.

These and other objects can be achieved by a process for preparing surface deposits of polyimide polymers referred to as FIPOL I, FIPOL II and FIPOL III on a solid substrate of various nature, particularly those based upon inorganic oxide such as, for example, glass, SiO₂, Al₂O₃ or metals such as Ti, Cu, Al or non-metals such as Si, C, Ge, comprising the steps of:
a) hard vacuum simultaneous evaporation of the polymeric precursors and of the metal following on the heating under thermal control conditions such as to assure a homogeneous evaporation rate.
b) deposition of the vapours produced in a) on a chemical solid substrate which may be made of inorganic oxides, metals and non-metals so as to provide a homogeneous film on the whole surface concerned.
c) stabilization of the film by heating in an inert atmosphere so as to provide a compact, homogeneous deposit of determined thickness;
thus obtaining a thin film that exhibits the chemical-physical characteristics of the massive material under thermal treatment in an inert atmosphere.

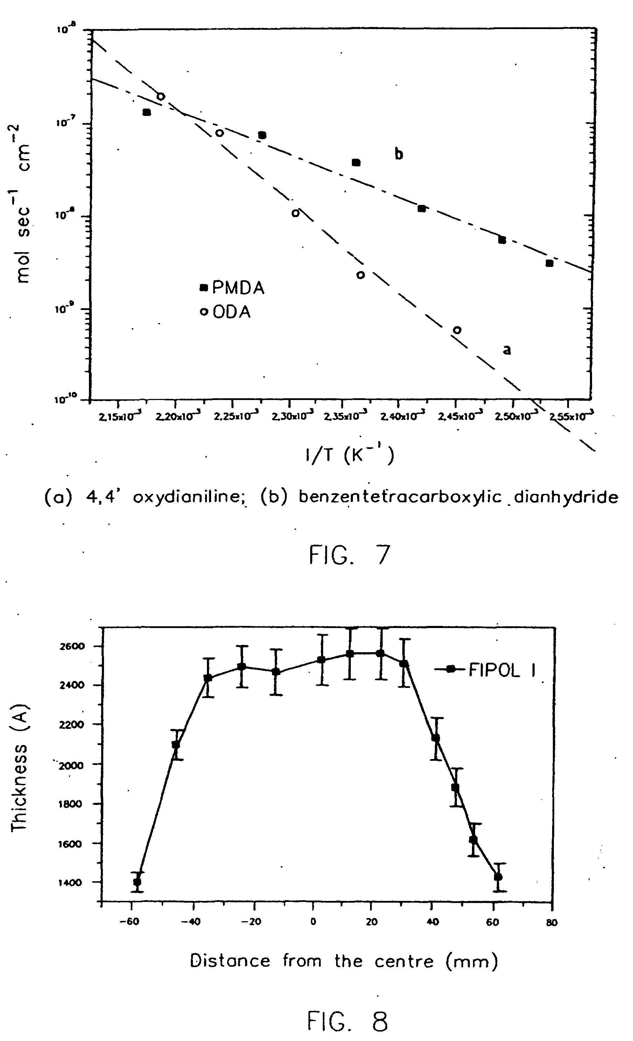

It was surprisingly found that the molar evaporation rate of both precursors (as for FIPOL I, benzentetracarboxylic dianhydride and 4,4'-oxydianiline; as for FIPOL II, biphenyltetracarboxylic dianhydride and 1,4-phenylendiamine-dianiline; as for FIPOL III, benzophenontetracarboxylic dianhydride and tetramethyl-p-phenylendiamine) is the same at the temperature of 180°C as shown in the diagrams of Fig. 7a relating to the evaporation rate of 4,4'-oxydianiline (ODA) and Fig. 7b relating to the evaporation rate of (benzentetracarboxylic dianhydride (PMDA).

Therefore, a first aspect of the invention provides that the heating for the evaporation of the precursors takes place under a temperature control system. Particularly; such a control is carried out by using a series of melting pots placed within a vacuum chamber and having a particular geometry and being provided with their own heating means for a controlled-temperature heating.

A second aspect of the invention provides the change of the distance between melting pot and substrate to be coated by a suitable mechanical device.

A third aspect of the invention provides the controlled evaporation of the polymeric precursors simultaneously to that of the organometal compositions, the low-melting-point metals, and other chemical compositions which can be sublimed.

A further aspect of the invention provides the polyimide film thickness control by controlling the evaporation time.

In order to achieve such objects and to provide the above-mentioned process the invention makes use of a device according to the features of independent claim 2.

The main advantages provided by the process according to the present invention are:
(i) preparation of homogeneous films of stable polymers or compositions thereof with metals on substrates such as metals, inorganic oxides or non-metals of varied geometry under simple operative conditions;
(ii) capability of modulating the process so as to be able to vary the thickness of the film according to the evaporation time and the kind of the substrate;
(iii) providing such surface deposits without any limitation in the extension of the treated surface, without discontinuity or modifications of the chemical-physical characteristics of the deposited polymer.

Further characteristics and advantages of the invention will be more readily apparent from the following description of the apparatus and three examples showing by way of an indicative, not limiting example the process according to the invention with reference to the accompanying drawings in which:
Fig. 1 shows schematically and generally an elevation front view of the device according to the invention with the vacuum chamber and the vacuum system;
Fig. 2 shows still schematically an elevation front view of the melting pot system used for the evaporation of the precursors and supported by flange A of the device of Fig. 1;
Fig. 3 is still an elevation front view of the mechanical device supported by flange B of Fig. 1 for controlling the melting pot-substrate distance;
Fig. 4 is a side view of flange C of Fig. 1 with the thickness gauge and the vacuometer;
Fig. 5 is a top plan view of flanges B and C of Fig. 1;
Fig. 6 is a perspective view of the melting pot system of Fig. 2;
Fig. 7 is a diagram showing the evaporation rate of the precursors of FIPOL I vs. the temperature;
Fig. 8 is a diagram showing the homogeneity of the thickness of the FIPOL I deposit;
Fig. 9 is the RBS spectrum of a CONPOL sample deposited on Si where the analysis beam is formed of protons energized at 1,5 MeV;
Fig. 10 is a schematic view of a continuously rotating mechanical device for coating cylindrical substrates;
Fig. 11 shows the diagram of the erosion rate in 40% HF of a glass cylinder before and after being coated with FIPOL I;

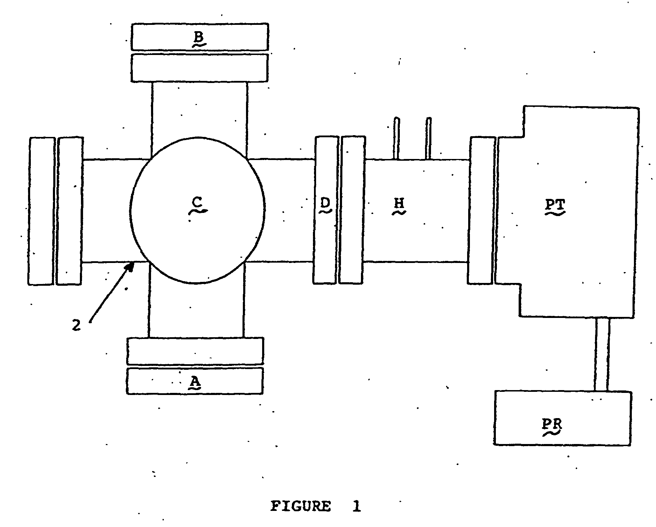

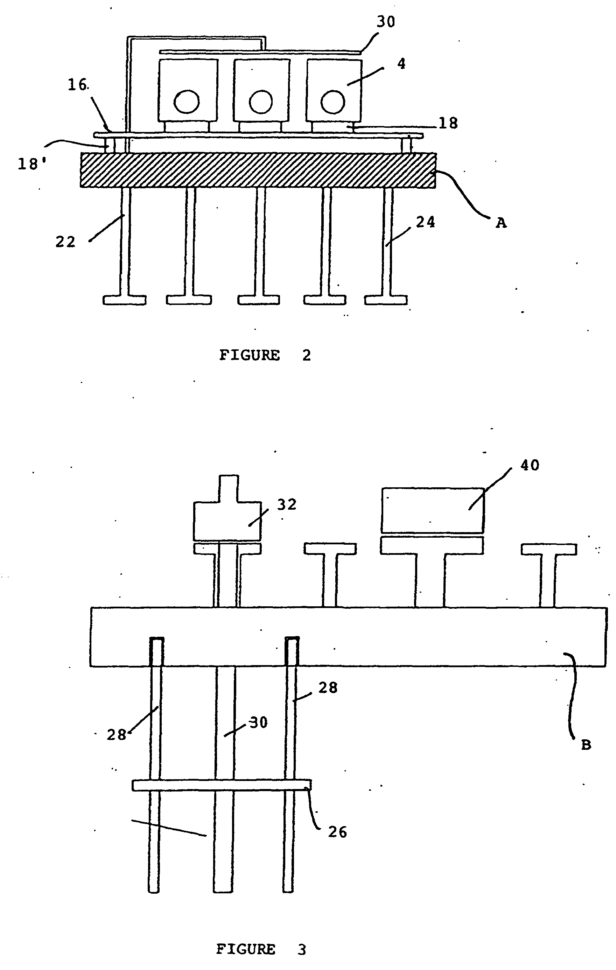

With reference to Figs. 1 to 6, the device for carrying out the process according to the invention essentially includes:
a conventional vacuum chamber 2 with six mouths having orthogonal axes and provided with flanges, to one of which, indicated at D,' the vacuum system formed of a turbomolecular pump PT and a rotating pump PR is connected through a cold junction H, and
a series of melting pots 4 formed of parallelepipeds of ultrapure copper provided with a central cavity 6 in which a mixture of precursors is placed and with two through holes 8 and 10 receiving the vacuum thermocouple..12 and the heating tubular resistance 14, respectively, both connected to a thermal regulation unit carrying out the automatic control of the temperature and keeping the variation thereof within 1°C.

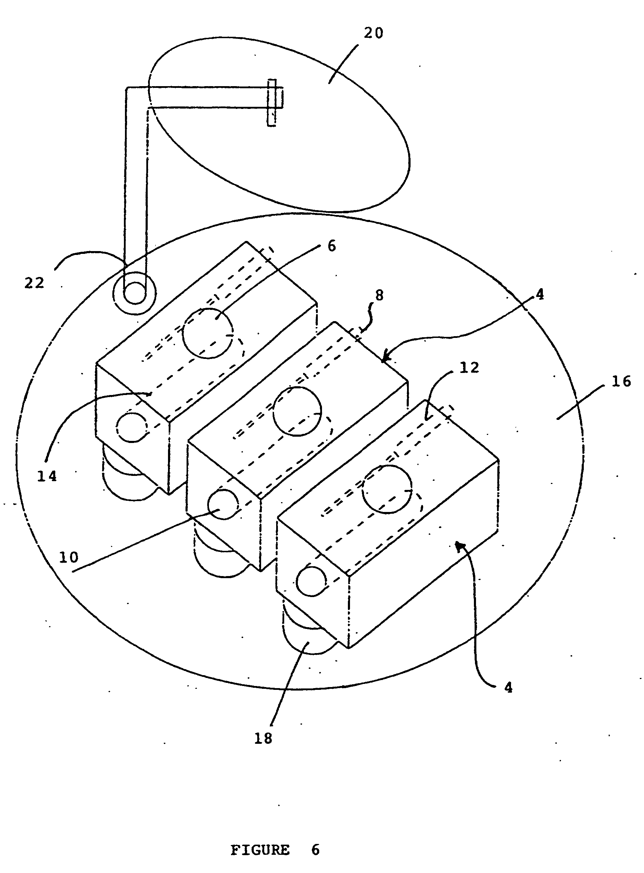

The melting pots are spaced apart regularly in a row with the interposition of ceramic spacers 18 on a support plate 16 of aluminium which is supported by flange A through further ceramic spacers 18' under the rotary shutter 20 fixedly connected to a vacuum-tight rotary tubular member 22 passing through the plate. Further passing tubular members 24 are provided for the connection to the power supply and the thermocouples. The geometric arrangement shown in Fig. 6 is, of course, indicating and not limiting as the active surface may be extended by using coupled melting pots.

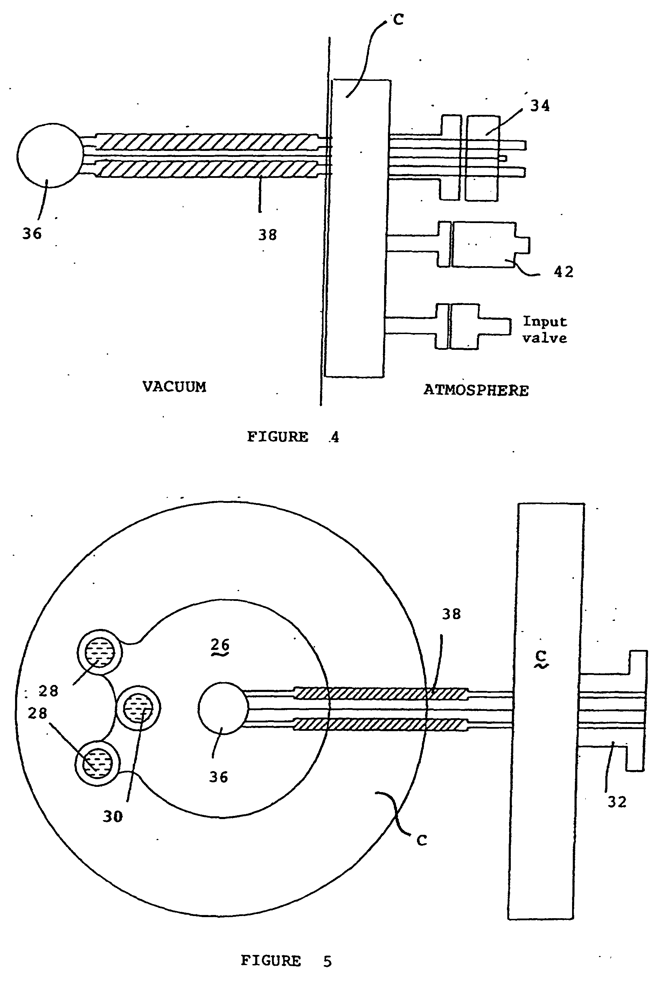

The distance between melting pots and surfaces of the substrate to be treated can be set through a mechanical system illustrated in Figs. 3 and 5.

As can be seen in such figures, the substrate to be treated is placed on a sample carrying plate 26 which is slidable along two vertical guide rods integral with flange B and is moved by a worm screw 30 connected to a rotary member 32 near a vacuometer 40.

The evaporation of the precursors at 180°C is obtained with constant flow and unit mole ratio by putting both precursors in one melting pot. The vapours are deposited on the solid substrate to be treated so as to provide a homogeneous film on the whole surface concerned. Such a result takes place, for example, in case of deposits of FIPOL I on Si under the above-mentioned conditions.

A thickness gauge or profilometer, the head 36 of which is cooled by two anacondas (hoses) 38 for supplying cooling water, is supported by a vacuum-tight passing member on flange C (Fig. 4). A vacuometer is indicated at 42.

The thicknesses of the film deposits shown in Fig. 8 are obtained after an evaporation treatment of 6 hours and can be detected by the profilometer after heating at 250°C in a nitrogen atmosphere. Up to a distance of 4 cm from the central axis of evaporation there is no thickness variation in case of an arrangement of three melting pots located on a strip of 8 cm, as shown in Fig. 6.

Fig. 8 shows that the thickness variation of the film is by 20% as a maximum at a distance of 10 cm.

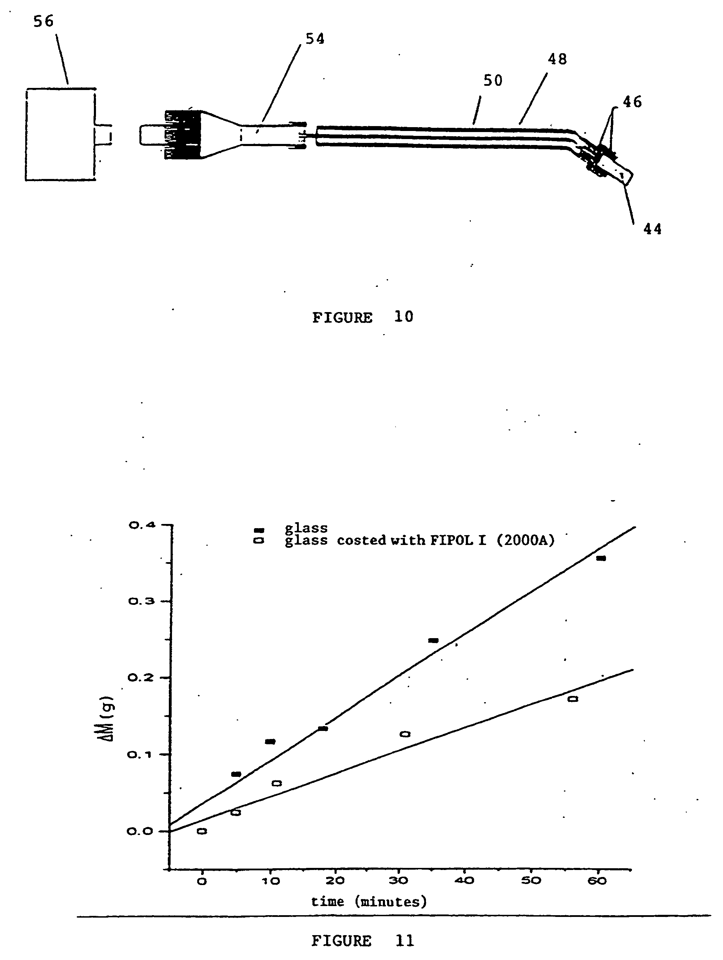

The mechanical apparatus of Fig. 10 is capable of coating cylindrical substrates by continuously rotating the substrate within the vacuum chamber. As can be seen, the cylindrical substrate to be coated 44 is supported by a bush 46 of teflon® connected to a wire 48 of harmonic steel. The latter is guided by a steel tube 50 and is connected at the opposite end to a bush 52 of musmetal integral with the. rotation pin of a rotary vacuum-tight passing member 54 externally connected to a motor 56.

The following example explain in a better way the characteristics of the process and the products obtained according to the invention.

### EXAMPLE

A deposit of a composite material FIPOL I-Pt was carried out on polycrystalline silicium with simultaneous deposition of the precursors (benzentetracarboxylic dianhydride and 4,4'-oxydianiline) and Pt (1,5 C₈H₁₂)C₁₂. The Pt composition was sublimed in advance without other components and an evaporation rate of 5 nm/h at 205°C was obtained. A film on a sapphire was produced through simultaneous evaporation of said composition, placed in the central melting pot at 205°C, and the two precursors of FIPOL I, placed in the side melting pots at 182°C. Such a film subjected to a thermal treatment under N₂ for 2 hours at 250°C is a homogeneous dispersion of Pt in FIPOL I (Fig. 7) as ascertained by RBS analysis (Rutherford Backscattering Spectrometry). The atomic ratio between Pt and C is about 1/28.

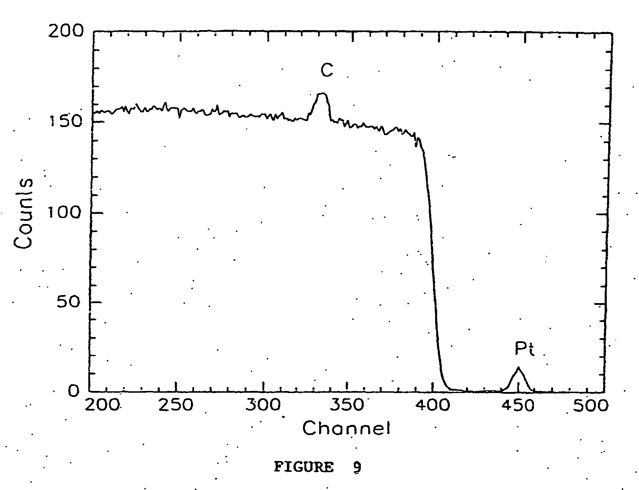

Such a material was referred to as CONPOL. Samples of such a material were subjected to measurements of electrical surface resistivity and the results are shown in Fig. 9. The surface resistivity becomes stable after about 60 minutes and reaches the typical values of the half-insulating materials. The non-ohmic characteristics are shown in the same figure.

The results shown in the figures confirm the advantages of the process for providing surface deposits of the present invention.

Particularly the preparation of the surface deposits of composite materials finds a wide application with reference to parts of radiation detectors such as the microstrip gas chambers and the microgap chambers since it is possible to deposit films on a very great number of different substrates: the polymer film assures a chemical-physical stability for the substrate against corrosion and damages due to radiations by modifying the wettability and the electrical-mechanical surface characteristics.

The present invention is described and illustrated on the base of a preferred embodiment thereof. It should be understood that a number of construction modifications and changes may be made by those skilled in the art without departing from the scope of the present industrial invention as defined in the following claims.

## Claims

1. A process for the deposition of thin films of polyimide-metal composite materials comprising the steps of:
a) hard vacuum evaporation of the polymeric precursors simultaneously with the organometal compositions, low-melting-point metals, and other chemical compositions which can be sublimed, said precursors and said compositions and metals being heated under thermal control conditions such as to assure a homogeneous evaporation rate;
b) deposition of the vapours produced in a) on a chemical solid substrate, having whatever geometric form and chemical composition, which may be made of glass, inorganic oxides, metals and non-metals so as to provide a homogeneous film on the whole surface concerned;
c) stabilization of the film by heating in an inert atmosphere so as to provide a compact, homogeneous deposit of determined thickness;
thus obtaining a thin film that exhibits the chemical-physical characteristics of the massive material under thermal treatment in an inert atmosphere.

2. A device for carrying out the process of claim 1, comprising a vacuum chamber adapted to contain a series of melting pots of suitable geometry for the evaporation of the precursors, each melting pot being provided with its own heating system with automatic temperature control, means for varying the distance between the melting pot and the substrate to be treated and means for controlling the evaporation time being also provided.

3. The device according to claim 2, **characterized in that** the geometry and the number of the melting pots change in order to provide deposits of varying thickness and composition or in case of substrate surfaces of particular geometry.

4. Polyimide-metal composite materials having the electrical characteristics of the half-insulating materials provided by simultaneous evaporation of the polyimide precursors and the metal.

5. Use of the surface deposits provided by the processes of the preceding claims as chemically inert films against corrosion and deterioration due to environmental conditions, or as protection of devices subjected to particular physical stress.

6. Use of the surface deposits provided by the processes of the preceding claims and having the surface resistivity typical of the half-insulating materials as detectors of particles and radiations on electrical and electronic devices.

## Patentansprüche

1. Verfahren zur Niederschlagung dünner Filme aus Polyimid-Metall-Verbundmaterialien mit den nachfolgenden Schritten:
(a) Hochvakuumverdampfung der Polymervorläufer zusammen mit den Organometallverbindungen, Metallen mit niedrigem Schmelzpunkt und anderen chemischen Verbindungen, die sublimierbar sind, wobei die Vorläufer und die Zusammensetzungen und Metalle unter kontrollierten thermischen Bedingungen erhitzt werden, um eine homogene Verdampfungsrate sicherzustellen;
(b) Niederschlagung der in (a) produzierten Dämpfe auf einem festen chemischen Substrat von beliebiger geometrischer Form und chemischer Zusammensetzung, die aus Glas, anorgischen Oxiden, Metallen oder Nichtmetallen hergestellt sein kann, um einen homogenen Film auf der gesamten betroffenen Oberfläche bereitzustellen;
(c) Stabilisierung des Films durch Erhitzen in einer inerten Atmosphäre, um einen dichten, homogenen Niederschlag von bestimmter Dicke bereitzustellen, wodurch ein dünner Film erhalten wird, der die chemisch-physikalischen Eigenschaften des massiven Materials unter Hitzebehandlung in einer inerten Atmosphäre aufweist.

2. Vorrichtung zum Ausführen des Verfahrens nach Anspruch 1, umfassend eine Vakuumkammer, die so ausgelegt ist, dass sie eine Reihe von Schmelztiegeln geeigneter Geometrie zur Verdampfung der Vorläufer enthält, wobei jeder Schmelztiegel mit seinem eigenen Erhitzungssystem mit automatischer Temperaturkontrolle ausgestattet ist, wobei weiterhin Mittel zum Verändern der Entfernung zwischen dem Schmelztiegel und dem zu behandelnden Substrat und Mittel zum Einstellen der Verdampfungszeit vorgesehen sind.

3. Vorrichtung nach Anspruch 2, **dadurch gekennzeichnet, dass** die Geometrie und die Anzahl der Schmelztiegel wechseln, um Ablagerungen unterschiedlicher Dicke und Zusammensetzung oder im Falle von Substratoberflächen von bestimmter Geometrie bereitzustellen.

4. Polyimid-Metall-Verbundmaterialien mit den elektrischen Eigenschaften der Halbisolierenden Materialien, bereitgestellt durch gleichzeitige Verdampfung der Polyimidvorläufer und des Metalls.

5. Verwendung der durch die Verfahren der vorhergehenden Ansprüche bereitgestellten Oberflächenablagerungen als chemisch inerte Filme gegen Korrosion und Schädigung aufgrund der Umweltbedingungen, oder als Schutz von Vorrichtungen, wenn sie bestimmten physikalischen Beanspruchungen ausgesetzt werden.

6. Verwendung der durch die Verfahren der vorhergehenden Ansprüche bereitgestellten Oberflächenablagerungen, die den für Halb-isolierende Materialien typischen Oberflächenwiderstand aufweisen, als Detektoren für Teilchen und Strahlungen auf elektrischen und elektronischen Vorrichtungen.

## Revendications

1. Procédé de dépôt de films fins de matériaux composites en polyimide-métal, comprenant les étapes :
a) d'évaporation sous vide poussé des précurseurs polymériqucs simultanément avec les compositions organométalliques, des métaux à bas point de fusion et d'autres compositions chimiques pouvant être sublimées, lesdits précurseurs et lesdits compositions et métaux étant chauffés dans des conditions commandées en température de façon à garantir une vitesse d'évaporation homogène ;
b) de dépôt des vapeurs produites en a) sur un substrat chimique solide, présentant une forme géométrique et une composition chimique quelconques, pouvant être fait de verre, d'oxydes inorganiques, de métaux et de non métaux de façon à fournir un film homogène sur l'ensemble de la surface concernée;
c) de stabilisation du film par chauffage dans une atmosphère inerte de façon à fournir un dépôt compact et homogène d'épaisseur déterminée;
pour obtenir alors un film fin qui présente les caractéristiques physico-chimiques du matériau massif sous traitement thermique dans une atmosphère inerte.

2. Appareil permettant de réaliser le procédé de la revendication 1, comprenant une chambre à dépression adaptée pour contenir une série de creusets de géométrie appropriée pour l'évaporation des précurseurs, chaque creuset étant muni de son propre système de chauffage avec commande automatique de la température, des moyens pour faire varier la distance entre le creuset et le substrat à traiter et des moyens permettant de commander la durée d'évaporation étant aussi prévus.

3. Appareil selon la revendication 2, **caractérisé en ce que** la géométrie et le nombre des creusets changent pour fournir des dépôts d'épaisseurs et de compositions variables ou en cas de surfaces de substrat de géométrie particulière.

4. Matériaux composites en polyamide-métal présentant les caractéristiques électriques des matériaux semi-isolants, fournies par évaporation simultanée des précurseurs de polyimide et du métal.

5. Utilisation des dépôts de surface fournis par les procédés des revendications précédentes en tant que films chimiquement inertes contre la corrosion et la détérioration dues à des conditions environnementales, ou en tant que protection de dispositifs soumis à une contrainte physique particulière.

6. Utilisation des dépôts de surface fournis par les procédés des revendications précédentes et présentant la résistivité de surface typique des matériaux semi-isolants, en tant que détecteurs de particules et de rayonnements sur des appareils électriques et électroniques.
